# EUROPÄISCHE PATENTSCHRIFT

(11) **EP 2 237 420 B1**
(45) Veröffentlichungstag und Bekanntmachung des Hinweises auf die Patenterteilung: **05.08.2015**
(21) Anmeldenummer: 09175769.0
(22) Anmeldetag: 12.11.2009
(51) Int. Cl.: H03K 17/687, H03K 17/12, H02J 7/00

(54) **Halbleiterrelais**
Semiconductor relay
Relais semi-conducteur

(30) Priorität: 31.03.2009 DE 202009002013 U
(43) Veröffentlichungstag der Anmeldung: 06.10.2010
(73) Patentinhaber: Kliem, Thomas, 78628 Rottweil (DE)
(72) Erfinder: Kliem, Thomas, 78628 Rottweil (DE)
(74) Vertreter: Gustorf, Gerhard

(56) Entgegenhaltungen:
- DE-A1- 10 046 668
- US-A- 5 081 411
- US-A- 6 118 676

## Beschreibung

Die Erfindung betrifft ein Halbleiterrelais zum Schalten von Verbrauchern nach dem Oberbegriff des Patentanspruchs 1 und geht aus von dem am nächsten kommenden Stand der Technik gemäß US 5 081 411 A. Hierbei handelt es sich um eine Regelstufe mit Wechselstromquelle oder Gleichstromquelle, die über Sensoren gesteuert wird.

In herkömmlicher Technik wurden zum Schalten von Verbrauchern, beispielsweise in Industrieanlagen oder Kraftfahrzeugen, elektromagnetische Relais eingesetzt, um eine Last, beispielsweise eine induktive oder eine kapazitive Last, stromlos zu schalten. Elektromagnetische Relais haben jedoch den Nachteil, dass sie viel Bauraum benötigen und relativ langsam schalten. Außerdem nehmen sie verhältnismäßig viel elektrische Leistung auf und sind störanfällig.

Es wurde daher versucht, zur Vermeidung dieser Nachteile Transistoren für Relais zu verwenden, um die Schaltzeit erheblich abzukürzen und um die Stromaufnahme deutlich zu reduzieren. Dabei hat sich jedoch gezeigt, dass beispielsweise n-Kanal Feldeffekttransistoren nicht zu dem gewünschten Ergebnis führen, weil diese eine aufwendige Ansteuerelektronik mit Ladungspumpe benötigen würden.

Der Erfindung liegt die Aufgabe zugrunde, ein Halbleiterrelais so auszubilden, dass auch bei hohen Leistungen eine rasche Schaltbarkeit gewährleistet ist, um einen Verbraucher durch Trennen von Masse rasch und ohne die oben erläuterten Probleme und insbesondere ohne Zerstörung des Halbleiterrelais von der Versorgungsspannung beispielsweise einer Batterie zu trennen.

Die Lösung dieser Aufgabe ergibt sich aus den Merkmalen des Patentanspruchs 1.

Dabei ist es vorteilhaft, wenn der Feldeffekttransistor als selbstsperrender Power-MOS-FET vom Anreicherungstyp zum Schalten hoher Leistungen ausgebildet ist, beispielsweise 50 A x 24 V = 1.200 W.

Das gemäß der Erfindung ausgebildete Halbleiterrelais benötigt einen wesentlich geringeren Betriebsstrom als elektromechanische Relais. Wenn die Versorgungsspannung von einer Batterie geliefert wird, erhöht sich dadurch die Entladungszeit der Batterie erheblich. Wenn das Halbleiterrelais gemäß der Erfindung als Batterietrennrelais verwendet wird, bleibt die Batterie permanent eingeschaltet. Bei Einsatz von elektromechanischen Relais hat das zur Folge gehabt, dass die Batterie eines Fahrzeugs schon nach kurzer Zeit entladen war. Dies stellte vor allem bei Lastkraftwagen oder Bussen ein großes Problem dar, weil deren Batterien nach kurzer Stillstandzeit nicht mehr einsatzfähig waren.

Ein wesentlicher Vorteil der Erfindung besteht darin, dass die Leistungsaufnahme von MOS-FET-Schaltkreisen gering ist. Die Ansteuerungen erfolgen damit nahezu leistungslos, weil MOS-FET-Transistorsysteme extrem große Eingangswiderstände haben.

Gemäß der Erfindung ist das Halbleiterrelais mit einer Ansteuerelektronik ausgerüstet. Der Grund hierfür ist, dass ein p-Kanal MOS-FET eine hohe Ansteuerspannung von wenigstens 10 Volt am Gate benötigt. Bei einer diesen Grenzwert unterschreitenden Spannung geht der Feldeffekttransistor in den Analogbetrieb über, was die Gefahr einer Überlastung mit sich bringt. Um das zu verhindern, ist die Ansteuerelektronik vorgesehen, die als Unterspannungsschutz die Baugruppe mit dem FET zwangsweise abschaltet.

In weiterer Ausgestaltung der Erfindung ist in dem Halbleiterrelais ein Zeitverzögerungsglied vorgesehen, das in Reihe zwischen die Diodenordnung und den MOS-FET geschaltet ist.

Die gesamte Baugruppe kann in einem Gehäuse aus einer wärmeleitenden Vergussmasse eingebettet werden, die die Wärmeableitung vom Halbleiter zur Gehäusewand unterstützt.

Das Gehäuse kann eine rechteckige Bodenplatte mit Steckkontaktelementen aufweisen, die vertauschungssicher und kompatibel mit genormten Steckrelais elektromagnetischer Bauweise sind. Damit kann ein elektromagnetisches Relais problemlos gegen ein Halbleiterrelais gemäß der Erfindung ausgetauscht werden.

Um die Verlustleistung bei den elektronischen Bauteilen möglichst gering zu halten, können mehrere Feldeffekttransistoren in dem Halbleiterrelais parallel geschaltet werden, beispielsweise fünf FET.

Weitere Merkmale und Vorteile der Erfindung ergeben sich aus den Unteransprüchen und aus der folgenden Beschreibung eines Ausführungsbeispiels, das in der Zeichnung dargestellt ist. Es zeigen:
Figur 1 ein Schaltbild eines Halbleiterrelais gemäß der Erfindung,
Figur 2 einen Ausschnitt aus dem Schaltschema der Figur 1, in der die mögliche Ausgestaltung der Eingangsdiodenanordnung gezeigt ist,
Figur 3 die Unterspannungsschutzschaltung mit Zeitverzögerungsglied Δt der Figur 2,
Figur 4 die Ansicht eines Gehäuses für das Halbleiterrelais gemäß der Erfindung,
Figur 5 die Unteransicht des Gehäuses der Figur 4 und
Figur 6 das Steckerbild der Figur 5.

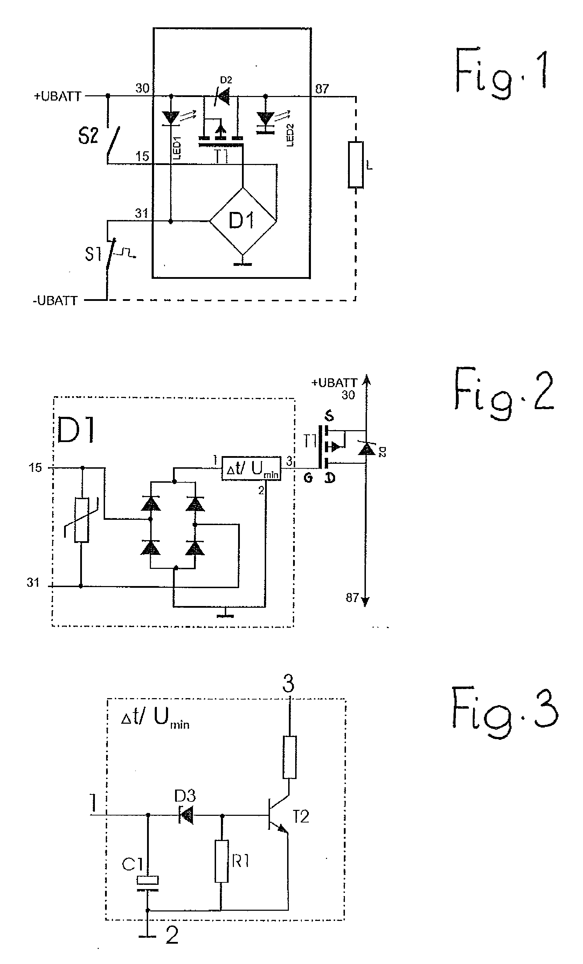

Figur 1 zeigt ein Schaltbild des Halbleiterrelais gemäß der Erfindung mit einer Diodenanordnung D1, die über die Klemmen 15 und 31 an eine Versorgungsspannung angeschlossen ist, beispielsweise einer Batterie. Der positive Pol der Batterie + UBATT ist über einen Eingangsschalter S2 an die Diodenanordnung D1 angeschlossen, während der negative Pol - UBATT über einen Schutzschalter S1 an die Klemme 31 der Diodenanordnung D1 angeschlossen ist.

Während ein Ausgang der Diodenanordnung D1 mit Masse 31 verbunden ist, führt ein zweiter Ausgang zum Gate G eines Feldeffekttransistors T1, der, wie Figur 1 zeigt, als p-Kanal MOS-FET ausgebildet ist. Zwischen Drain D und Source S des Transistors T1 ist ein Überspannungsschutzelement geschaltet, das im dargestellten Ausführungsbeispiel der Figur 1 aus einer Suppressordiode D2 besteht.

Wie Figur 1 weiter zeigt, ist zwischen Drain D des Transistors T1, der zur Klemme 87 führt, und den negativen Pol - UBATT eine Last L geschaltet, die von dem Halbleiterrelais gemäß der Erfindung geschaltet wird.

In Figur 2 ist ein mögliches Schaltbild für die Diodenanordnung D gezeigt, die als Verpolschutz dient und hier aus einem Brückengleichrichter mit vier Dioden besteht. Zwischen die Anschlussklemmen 15 und 31 der Diodenanordnung D1 ist ein Schutzelement gegen Überspannung geschaltet, das im dargestellten Ausführungsbeispiel aus einem Varistor V besteht. Dabei handelt es sich um einen spannungsabhängigen Widerstand, dessen elektrischer Widerstand bei konstanter Temperatur mit zunehmender Spannung stark abnimmt.

Wie Figur 2 zeigt, ist zwischen die Brückenschaltung der Diodenanordnung D1 und das Gate G des MOS-FET T1 eine Ansteuerelektronik mit einer Unterspannungsschutzschaltung Δt/Uₘᵢₙ geschaltet, deren Schaltbild in Figur 3 dargestellt ist. Das Zeitverzögerungsglied Δt, das in die Unterspannungsschutzschaltung integriert ist und aus dem Kondensator C1, dem Widerstand R1 und der Diode D3 besteht, dient zur Ausschaltverzögerung am Eingang 15, um bei Netzschwankungen ein ungewolltes Ein- und Ausschalten zu vermeiden. Damit wird verhindert, dass sich bei kurzen Spannungsschwankungen im Netz das Relais versehentlich ausschaltet. Wenn das Relais über dem Schutzschalter S1 abgeschaltet wird, erfolgt diese Abschaltung unverzüglich.

Da ein MOS-FET erst ab einer Mindestspannung Gate-Source von etwa 10 Volt durchschaltet, ist die in Figur 3 näher dargestellte Unterspannungsschutzschaltung vorgesehen. Diese gewährleistet, dass das Relais erst ab einer Spannung von mehr als etwa 12 Volt angesteuert werden kann. Bei kleineren Spannungen würde der Durchlasswiderstand RDS ON des MOS-FET so stark ansteigen, dass die Verlustleistung bei unverändertem Laststrom weiter ansteigen würde, bis der Transistor zerstört würde. Die Funktionsweise der Unterspannungsschutzschaltung ist wie folgt:
Der Transistor T2, der das Gate G des Transistors T1 ansteuert, wird aufgrund der Zenerdiode D3 erst ab einer Steuerspannung von mehr als 12 Volt an der Diodenanordnung D1 durchgeschaltet; erst dann wird das Gate G von T1 angesteuert. Bei kleinerer Spannung an der Diodenanordnung D1 sperrt der Transistor T2 das Gate G des Transistors T1, der dadurch ausgeschaltet wird.

Das Schaltbild der Figur 1 zeigt zwei Leuchtdioden zum Anzeigen des Betriebszustandes. Dabei zeigt die LED 1 an, wenn von dem Pluspol + UBATT Strom zu Masse 31 fließt, während LED 2 anzeigt, dass die Baugruppe insgesamt eingeschaltet ist.

Der Einsatz des p-Kanal MOS-FET in der Baugruppe des Halbleiterrelais gemäß der Erfindung hat den Vorteil, dass die Baugruppe nicht nur über den Eingang 15 ein- und ausgeschaltet werden kann und darf, sondern auch durch Wegschalten der Masse 31. Wenn die Baugruppe über die Klemme 15 ein- bzw. ausgeschaltet wird, greift die Zeitverzögerung Δt, während dann, wenn die Klemme 31 über den Schutzschalter S1 stromlos geschaltet ist, die gesamte Baugruppe unverzüglich abgeschaltet wird.

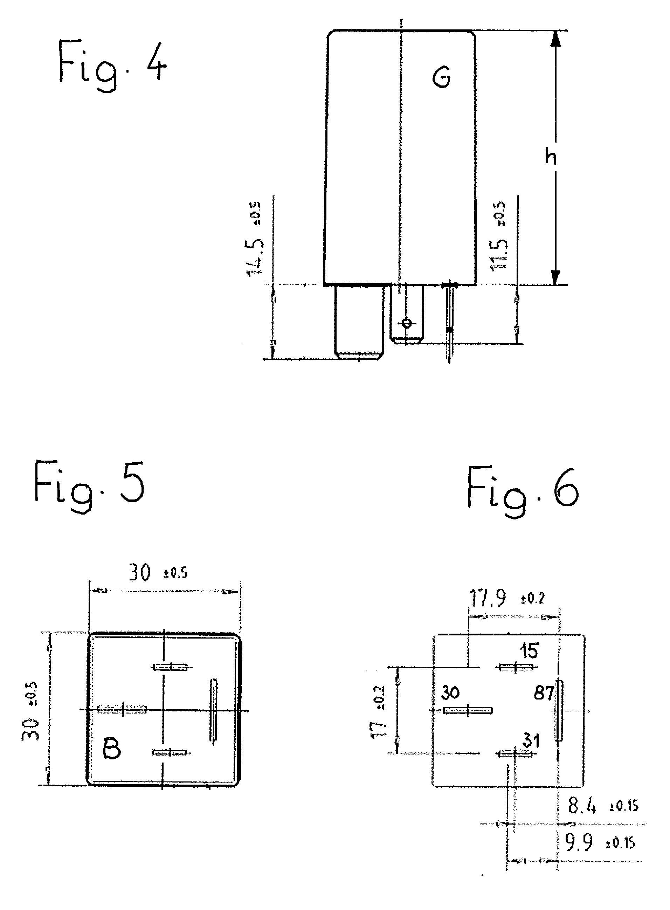

Die Figuren 4 und 5 zeigen ein Gehäuse H (Höhe h = 40 mm) mit einer quadratischen Bodenplatte B, in dem die gesamte Baugruppe mittels einer wärmeleitenden Vergussmasse eingebettet ist. Von der Bodenplatte B stehen flache, genormte Steckkontaktelemente (DIN 46 244 A) ab, deren Steckerbild in Figur 6 gezeigt ist. Dieses Steckerbild ist kompatibel mit genormten elektromagnetischen Steckrelais, so dass ein problemloser Austausch möglich ist. Die Steckkontaktelemente sind dabei hinsichtlich ihrer Maße und Abstände vertauschungssicher, so dass die Eingänge 15 und 31 verpolsicher sind, damit beim Austausch gegen ein herkömmliches, elektromechanisches Relais das Halbleiterrelais gemäß der Erfindung richtig angeschlossen wird. Die Steckkontaktelemente (Pins) für die beiden Anschlüsse 30 und 87 haben nach DIN 46 244 A die Maße 9,5 x 1,2 mm, diejenigen für die beiden Anschlüsse 15 und 31 die Größe 6,3 x 0,8 mm (vgl. Figur 6).

## Patentansprüche

1. Halbleiterrelais zum Schalten von Verbrauchern, bestehend aus einer an den Verbraucher (L) und an eine Versorgungsspannung anschließbaren Baugruppe mit einer Diodenanordnung (D1) und wenigstens einem Transistor (T), **dadurch gekennzeichnet, dass** der Transistor (T1) ein p-Kanal MOS-FET ist, dessen Gate (G) über eine Ansteuerelektronik mit einer Unterspannungsschutzschaltung (Δt/Umin) an einen Ausgang der Diodenordnung (D1) in Form eines Brückengleichrichters mit vier Dioden angeschlossen ist, wobei der positive Pol (+ UBATT) einer die Versorgungsspannung erzeugenden Batterie über einen Eingangsschalter (S2) an einen Eingang der Diodenanordnung (D1) angeschlossen ist,
während zwischen Drain (D) des Transistors (T1) und den negativen Pol (-UBATT) eine Last (L) geschaltet ist, wobei die Unterspannungsschutzschaltung (Δt/Umin) bei Unterschreiten einer Mindeststeuerspannung (Umin) am Ausgang der Diodenanordnung (D1) den Transistor (T1) zwangszweise abschaltet.

2. Halbleiterrelais nach Anspruch 1, **dadurch gekennzeichnet, dass** der Feldeffekttransistor (T1) als selbstsperrender Power-MOS-FET zum Schalten hoher Leistungen ausgebildet ist.

3. Halbleiterrelais nach Anspruch 1 oder 2, **dadurch gekennzeichnet, dass** zwischen Source (S) und Drain (D) des MOS-FET (T1) ein Überspannungsschutzelement geschaltet ist.

4. Halbleiterrelais nach Anspruch 3, **dadurch gekennzeichnet, dass** das Überspannungsschutzelement aus einer Suppressordiode (D2) besteht.

5. Halbleiterrelais nach einem der vorhergehenden Ansprüche, **dadurch gekennzeichnet, dass** zwischen die Anschlussklemmen (15, 31) der Diodenanordnung (D) ein Schutzelement gegen Überspannung geschaltet ist.

6. Halbleiterrelais nach Anspruch 5, **dadurch gekennzeichnet, dass** das Schutzelement aus einem Varistor (V) besteht.

7. Halbleiterrelais nach einem der vorhergehenden Ansprüche, **dadurch gekennzeichnet, dass** in Reihe zwischen die Diodenanordnung (D) und den Feldeffekttransistor (T1) ein Zeitverzögerungsglied (Δt) geschaltet ist.

8. Halbleiterrelais nach Anspruch 7, **dadurch gekennzeichnet, dass** das Zeitverzögerungsglied (Δt) Teil der Ansteuerelektronik mit Unterspannungsschutzschaltung ist.

9. Halbleiterrelais nach einem der vorhergehenden Ansprüche, **dadurch gekennzeichnet, dass** wenigstens eine LED zur Anzeige des Betriebszustandes vorgesehen ist.

## Claims

1. Semiconductor relay for consumer commutation, consisting of an assembly to be connected to the consumer (L) and to a supply voltage, said assembly comprising a diode circuit (D1) and at least one transistor (T), **characterized in that** the transistor (T1) is a P-channel MOS-FET whose gate (G) is connected, via an electronic drive unit having an undervoltage protection circuit (Δt/Umin), to an output terminal of said diode circuit (D1) in form of a bridge connected rectifier having four diodes, wherein the positive pole (+UBATT) of a storage battery generating said supply voltage is connected through an input switch (S2) to an input of said diode circuit (D1), whereas a load (L) is inserted between the drain (D) of the transistor (T1) and the negative pole (-UBATT), and wherein said undervoltage protection circuit (Δt/Umin) will positively switch off the transistor (T1) in the case of a fall short of a minimum control voltage (Umin) at the output terminal of said diode circuit (D1).

2. Semiconductor relay according to claim 1, wherein said field effect transistor (T1) is a self-locking power MOS-FET for high-power commutation.

3. Semiconductor relay according to claim 1 or 2, wherein an overvoltage protection element is inserted between source (S) and drain (D) of said MOS-FET (T1).

4. Semiconductor relay according to claim 3, wherein said overvoltage protection element is a suppressor diode (D2).

5. Semiconductor relay according to any of the preceding claims, wherein an overvoltage protection element is inserted between the terminal plugs (15, 31) of said diode circuit (D).

6. Semiconductor relay according to claim 5, wherein said protection element is a varistor (V).

7. Semiconductor relay according to any of the preceding claims, wherein between said diode circuit (D) an the field effect transistor (T1) a time delay element (Δt) is connected in series.

8. Semiconductor relay according to claim 7, wherein said time delay element (Δt) is part of said electronic drive unit with undervoltage protection circuit.

9. Semiconductor relay according to any of the preceding claims, wherein at least one LED is provided as mode indicator.

## Revendications

1. Relais semi-conducteur pour la commutation de dissipateurs composé d'un ensemble comprenant un circuit à diodes (D1) et au moins un transistor (T), ledit ensemble étant apte à être relié au dissipateur (L) et à une tension d'alimentation, **caractérisé par le fait que** le transistor (T1) est un transistor MOS à effet de champ à canal P dont la grille (G) est reliée par un circuit éléctronique de commande avec un circuit à disjoncteur à minimum de tension (Δt/Umin) à une sortie du circuit à diodes (D1) formée par un redresseur à pont avec quatre diodes, le pôle positif (+UBATT) d'un accumulateur générant la tension d'alimentation étant relié par un interrupteur d'entrée (S2) à une entrée du circuit à diodes (D1), tandis qu'une charge (L) est inséré entre le drain (D) du transistor (T1) et le pôle négatif (-UBATT), ledit circuit à disjoncteur à minimum de tension (Δt/Umin) déconnectant à actionnement forcé le transistor (T1) dès que la tension à la sortie du circuit à diodes (D1) soit inférieure à une tension minimale de commande (Umin).

2. Relais semi-conducteur selon la revendication 1 **caractérisé par le fait que** le transistor à effet de champ (T1) est un transistor power MOS-FET à blocage automatique apte à la commutation de grandes puissances.

3. Relais semi-conducteur selon la revendication 1 ou 2, **caractérisé par le fait qu'**un élément à coupe-circuit de surtension est inséré entre la source (S) et le drain (D) du MOS-FET (T1).

4. Relais semi-conducteur selon la revendication 3, **caractérisé par le fait que** l'élément à coupe-circuit de surtension est une diode de suppression (D2).

5. Relais semi-conducteur selon une des revendications précédentes, **caractérisé par le fait qu'**un élément à coupe-circuit de surtension est inséré entre les bornes de raccord (15, 31) du circuit à diodes (D).

6. Relais semi-conducteur selon la revendication 5, **caractérisé par le fait que** ledit élément à coupe-circuit est un varistor (V).

7. Relais semi-conducteur selon une des revendications précédentes, **caractérisé par le fait qu'**un élément de retard de temps (Δt) est inséré en série entre le circuit à diodes (D) et le transistor à effet de champ (T1).

8. Relais semi-conducteur selon la revendication 7, **caractérisé par le fait que** l'élément de retard de temps (Δt) est une partie dudit circuit éléctronique de commande avec circuit à disjoncteur à minimum de tension.

9. Relais semi-conducteur selon une des revendications précédentes, **caractérisé par le fait qu'**au moins une diode DEL est prévue pour l'indication de l'état d'exploitation.
